# EUROPEAN PATENT APPLICATION

(11) **EP 4 757 515 A1**
(43) Date of publication of application: **10.06.2026**
(21) Application number: 24850849.1
(22) Date of filing: 29.07.2024
(51) Int. Cl.: H05K 7/20

(54) **EMERGENCY COOLING DEVICE FOR DATA CENTER**

(30) Priority: 04.08.2023 CN 202310982329
(71) Applicant: BEIJING YOUZHUJU NETWORK TECHNOLOGY CO. LTD., Beijing 101299 (CN)
(72) Inventor: MA, Binbin, Beijing 100028 (CN); LIU, Xuechao, Beijing 100028 (CN); WANG, Ning, Beijing 100028 (CN); WANG, Jian, Beijing 100028 (CN)
(74) Representative: Isarpatent
(86) International application number: PCT/CN2024/108298
(87) International publication number: WO 2025/031201

(57) **Abstract**

Embodiments of the present disclosure provide an emergency cooling supply device for a data center. The device includes a liquid supply pipe and a liquid return pipe configured to be connected to a liquid-cooled cabinet in the data center, a dry cooler connected to the liquid return pipe and configured to cool, with air, a coolant received from the liquid-cooled cabinet via the liquid return pipe, a first fan arranged adjacent to the dry cooler and configured to drive air to flow through the dry cooler, a liquid storage tank connected to the dry cooler via a first valve and configured to store coolant and mix the coolant received from the dry cooler with the stored coolant, and a circulating pump having an inlet connected to the liquid storage tank via a second valve and an outlet connected to the liquid supply pipe, the circulating pump being configured to circulate the coolant from the liquid storage tank to the liquid supply pipe and provide the coolant to the liquid-cooled cabinet via the liquid supply pipe.

## Description

The present application claims priority to Chinese Patent Application No. 202310982329.1, filed on August 4, 2023, and entitled "EMERGENCY COOLING SUPPLY DEVICE FOR DATA CENTER", which is hereby incorporated by reference in its entirety.

### FIELD

Embodiments of the present disclosure generally relate to the field of data center cooling technology, and more specifically, to an emergency cooling supply device for a data center.

### BACKGROUND

With the increasing proportion of the digital economy in social life and the rapid development of technologies such as cloud computing, the corresponding computing power requirements continue to increase, which makes the power density of the data center higher and higher. The increase in power density leads to an increasing amount of heat generated by cabinets in the computer room of the data center, and conventional cooling methods and technologies are difficult to meet the cooling requirements of high-density heat loads. To this end, the cold plate liquid cooling technology is becoming more and more mature and has been applied on a large scale.

Compared with the conventional cooling method, the biggest difference of the cold plate liquid cooling technology lies in the terminal cooling method, which directly takes away the heat generated by electronic devices such as servers or switches with a coolant with relatively low temperature. The cold plate liquid cooling technology can provide high heat dissipation efficiency, but when an end pipe of the liquid-cooled cabinet leaks, the cooling capacity required by the cabinet or the server cannot be satisfied, resulting in the server being affected or even shut down. Therefore, how to ensure a continuous cooling of the affected cabinets in the event of a liquid cooling system failure is a great challenge for the current data center operation and maintenance.

### SUMMARY

In an aspect of the present disclosure, there is provided an emergency cooling supply device for a data center, including: a liquid supply pipe and a liquid return pipe, configured to be connected to a liquid-cooled cabinet in the data center; a dry cooler, connected to the liquid return pipe and configured to cool, with air, a coolant received from the liquid-cooled cabinet via the liquid return pipe; a first fan, arranged adjacent to the dry cooler and configured to drive air to flow through the dry cooler; a liquid storage tank, connected to the dry cooler via a first valve and configured to store coolant and mix the coolant received from the dry cooler with the stored coolant; and a circulating pump, having an inlet connected to the liquid storage tank via a second valve and an outlet connected to the liquid supply pipe, the circulating pump being configured to circulate the coolant from the liquid storage tank to the liquid supply pipe and provide the coolant to the liquid-cooled cabinet via the liquid supply pipe.

It should be understood that the content described in this content part is not intended to limit the key or important features of the embodiments of the present disclosure, nor is it intended to limit the scope of the present disclosure. Other features of the present disclosure will become readily comprehensible through the following description.

### BRIEF DESCRIPTION OF DRAWINGS

The above and other features, advantages and aspects of the embodiments of the present disclosure will become more apparent when taken in conjunction with the drawings and with reference to the following detailed description. In the drawings, the same or similar reference numerals refer to the same or similar elements, among which:
FIG. 1 illustrates a schematic structural diagram of an emergency cooling supply device for a data center according to an embodiment of the present disclosure; and
FIG. 2 illustrates a schematic structural diagram of an emergency cooling supply device for a data center according to another embodiment of the present disclosure.

### DETAILED DESCRIPTION

Preferred embodiments of the present disclosure will be described in more detail below with reference to the drawings. While preferred embodiments of the present disclosure are shown in the drawings, it should be understood that the present disclosure may be embodied in various forms and should not be limited by the embodiments set forth here. On the contrary, these embodiments are provided for the purpose of making the present disclosure more thorough and complete, and being able to fully convey the scope of the present disclosure to those skilled in the art.

The term "include/comprise" and variations thereof as used herein represents an open-ended inclusion, that is, "include/comprise but not limited to". Unless specifically stated, the term "or" represents "and/or". The term "based on" represents "at least partially based on". The terms "one example embodiment" and "one embodiment" represent "at least one example embodiment". The term "another embodiment" represents "at least one additional embodiment". The terms "first", "second", etc. may refer to different or the same objects.

When a single or a small number of terminal cooling devices in an air-cooled computer room fails, it will not cause a great temperature rise of the cabinet in a short time, and the cooling requirement of the computer room can be satisfied by starting a standby machine or reducing the air supply temperature of the normally operating device. The liquid cooling system uses a coolant at a low temperature to flow through a cooling flow channel of electronic devices such as servers to take away heat generated by chips and the like. In the case where the liquid cooling system fails, due to the high heat generation density of the electronic devices, the conventional air-cooled emergency cooling supply manner may not satisfy the cooling requirement of the liquid-cooled cabinet. At present, there is no effective emergency measure in the industry to cope with extreme scenarios such as cutoff and leakage of coolant of the liquid-cooled cabinet, which may result in the server being affected or even shut down due to the failure to satisfy the cooling capacity required by the cabinet or the server. In this case, great challenges are brought to the service stability and service quality of the data center.

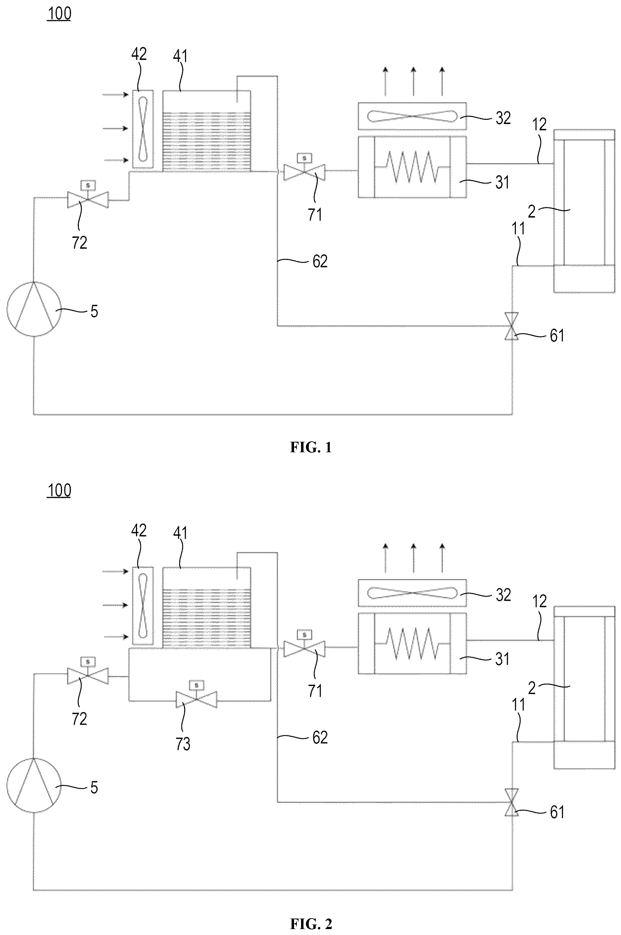

Embodiments of the present disclosure provide an emergency cooling supply device for a data center to ensure that a liquid-cooled cabinet can still operate reliably in the case where a cold plate liquid cooling system of the liquid-cooled cabinet fails, thereby avoiding the damage to electronic devices in the liquid-cooled cabinet caused by a heat event. Embodiments of the present disclosure will be described below with reference to FIG. 1 and FIG. 2.

FIG. 1 illustrates a schematic structural diagram of an emergency cooling supply device for a data center according to an embodiment of the present disclosure. As shown in FIG. 1, the emergency cooling supply device 100 described herein generally includes a liquid supply pipe 11, a liquid return pipe 12, a dry cooler 31, a first fan 32, a liquid storage tank 41, and a circulating pump 5. The liquid supply pipe 11 and the liquid return pipe 12 are used to connect to a liquid-cooled cabinet 2 in the data center. The dry cooler 31 is connected to the liquid return pipe 12 for cooling, with air, a coolant received from the liquid-cooled cabinet 2 via the liquid return pipe 12. The first fan 32 is arranged adjacent to the dry cooler 31 for driving air to flow through the dry cooler 31. The liquid storage tank 41 is connected to the dry cooler 31 via a first valve 71 for storing the coolant and mixing the coolant received from the dry cooler 31 with the stored coolant. An inlet of the circulating pump 5 is connected to the liquid storage tank 41 via a second valve 72, and an outlet of the circulating pump 5 is connected to the liquid supply pipe 11 for circulating the coolant from the liquid storage tank 41 to the liquid supply pipe 11 and providing the coolant to the liquid-cooled cabinet 2 via the liquid supply pipe 11.

In some embodiments, the emergency cooling supply device 100 may include a box (not shown) and rollers arranged on the box. Various functional components of the emergency cooling supply device 100 may be arranged in the box, such as the liquid supply pipe 11, the liquid return pipe 12, the dry cooler 31, the first fan 32, the liquid storage tank 41, the circulating pump 5, and other components. Nozzles of the liquid supply pipe 11 and the liquid return pipe 12 may protrude from the box so as to be connected to a liquid distribution manifold of the liquid-cooled cabinet 2. When it is necessary to perform emergency cooling on the liquid-cooled cabinet 2 with a liquid cooling system failure, an operator may push the emergency cooling supply device 100 to the vicinity of the liquid-cooled cabinet 2, and align and connect the nozzles of the liquid supply pipe 11 and the liquid return pipe 12 with the liquid distribution manifold of the liquid-cooled cabinet 2, so as to provide emergency cooling capacity to the liquid-cooled cabinet.

In some embodiments, a display may be arranged on the box for displaying an operating state of the emergency cooling supply device 100.

It should be understood that the box and the rollers are only example structures of the emergency cooling supply device 100. In other embodiments, the emergency cooling supply device 100 may be installed with various functional components in other manners, and may also be moved to the vicinity of the liquid-cooled cabinet 2 in other manners, and these alternative manners all fall within the scope of the present disclosure. In addition, the liquid distribution manifold is only an example interface of the liquid-cooled cabinet 2. In other embodiments, any suitable interface that can be matched with the nozzles of the liquid supply pipe 11 and the liquid return pipe 12 is feasible.

After the emergency cooling supply device 100 is connected to the liquid-cooled cabinet 2, the liquid supply pipe 11 may supply the low-temperature coolant to the liquid-cooled cabinet 2, thereby providing emergency cooling to the electronic devices in the liquid-cooled cabinet 2. The temperature of the coolant will rise after absorbing heat from the electronic devices. The heated coolant may return to the emergency cooling supply device 100 via the liquid return pipe 12 for recirculation.

As shown in FIG. 1, an input end of the dry cooler 31 is connected to the liquid return pipe 12, and an output end of the dry cooler 31 is connected to the liquid storage tank 41 via the first valve 71. The dry cooler 31 is provided with an internal pipeline, and the coolant may flow from the input end to the output end via the internal pipeline. The coolant in the internal pipeline may exchange heat with external air to dissipate heat into the air, thereby reducing the temperature of the coolant. In order to enhance heat exchange efficiency, a first fan 32 is arranged near the dry cooler 31, and the first fan 32 may drive air to flow through the dry cooler 31, thereby taking away heat emitted by the coolant in the internal pipeline. In the embodiments according to the present disclosure, the first fan 32 may drive the air to flow through the dry cooler 31 by drawing in air, blowing out air, a combination of the two manners, or any other suitable manner.

As shown in FIG. 1, the first valve 71 is arranged at an input end of the liquid storage tank 41, and the second valve 72 is arranged at an output end of the liquid storage tank 41. In the case where the emergency cooling supply device 100 is not applied to perform emergency cooling on the liquid-cooled cabinet 2, the first valve 71 and the second valve 72 are in a closed state to prevent the coolant in the liquid storage tank 41 from leaking. A certain amount of coolant may be stored in the liquid storage tank 41. After the emergency cooling supply device 100 is connected to the liquid-cooled cabinet 2, the first valve 71 and the second valve 72 may be opened so that the coolant flows in the loop under the driving of the circulating pump 5. When the emergency cooling supply device 100 is in operation, the liquid storage tank 41 may mix the coolant received from the dry cooler 31 with the stored coolant. In some embodiments, the first valve 71 and the second valve 72 may be electric valves, and the electric valves may have an opening and closing function or may further have an opening and closing degree adjustment function. In other embodiments, the first valve 71 and the second valve 72 may be manual valves or valves of any suitable type.

As shown in FIG. 1, an inlet of the circulating pump 5 is connected to the second valve 72, and an outlet of the circulating pump 5 is connected to the liquid supply pipe 11. Under the driving of the circulating pump 5, the coolant may be circulated from the liquid storage tank 41 to the liquid supply pipe 11 and provided to the liquid-cooled cabinet 2 via the liquid supply pipe 11, thereby providing emergency cooling to the electronic devices in the liquid-cooled cabinet 2. The temperature of the coolant will rise after absorbing heat from the electronic devices. The heated coolant may flow to the dry cooler 31 and the liquid storage tank 41 via the liquid return pipe 12 for recirculation.

According to the embodiments of the present disclosure, in the case where the cold plate liquid cooling system of the liquid-cooled cabinet 2 fails, the liquid supply pipe 11 and the liquid return pipe 12 of the emergency cooling supply device 100 may be connected to the liquid-cooled cabinet 2, thereby providing emergency cooling to the liquid-cooled cabinet 2. In this process, the coolant may be effectively cooled via the dry cooler 31, and mixed with the low-temperature coolant in the liquid storage tank 41, and then flow into the liquid-cooled cabinet 2 under the driving of the circulating pump 5. In this manner, the electronic devices in the liquid-cooled cabinet 2 can be reliably cooled urgently, thereby preventing the electronic devices from malfunctioning or even shutting down due to an excessive temperature.

When the emergency cooling supply device 100 is initially connected to the liquid-cooled cabinet 2, there may be gas in the pipeline of the emergency cooling supply device 100. After the first valve 71 and the second valve 72 are opened, the gas in the pipeline needs to be discharged. To this end, in some embodiments, as shown in FIG. 1, the emergency cooling supply device 100 further includes an exhaust valve 61 and an exhaust pipe 62. The exhaust valve 61 is arranged in the liquid supply pipe 11. One end of the exhaust pipe 62 is connected to the exhaust valve 61, and the other end is connected to the liquid storage tank 41. In the case where the first valve 71 and the second valve 72 are initially opened, the gas in the liquid supply pipe 11 may be discharged into the liquid storage tank 41 under the driving of the coolant. A filter screen may be arranged on a top end of the liquid storage tank 41 to discharge the gas into the air. With this arrangement, the gas in the pipeline of the emergency cooling supply device 100 can be efficiently and quickly discharged, thereby improving the heat dissipation efficiency of the coolant to the electronic devices in the liquid-cooled cabinet 2. In addition, after the gas in the pipeline of the emergency cooling supply device 100 is discharged, a small amount of coolant may flow into the liquid storage tank 41 via the exhaust pipe 62, which can prevent the coolant from leaking into the environment, thereby avoiding the waste, pollution and safety problems caused by coolant leakage.

In other embodiments, the gas in the pipeline of the emergency cooling supply device 100 may be discharged in other manners. For example, other types of valves may be arranged in the liquid supply pipe 11, and the valves may be closed when the exhaust is completed. This manner can also effectively discharge the gas in the pipeline of the emergency cooling supply device 100, but a little coolant may leak before the valves are closed, which may cause certain waste, pollution and safety problems.

In some embodiments, as shown in FIG. 1, the emergency cooling supply device 100 further includes a second fan 42, the second fan 42 is arranged adjacent to the liquid storage tank 41 to drive air to flow through the liquid storage tank 41, thereby further reducing the temperature of the coolant in the liquid storage tank 41. In the embodiments according to the present disclosure, the second fan 42 may drive air to flow through the liquid storage tank 41 by drawing in air, blowing out air, a combination of the two manners, or any other suitable manner.

In some embodiments, an operating state of at least one of the first fan 32, the second fan 42 and the circulating pump 5 may be adjusted based on the temperature of the coolant at the inlet and the outlet of the liquid-cooled cabinet 2. To this end, in some embodiments, the emergency cooling supply device 100 may further include a first temperature sensor and a second temperature sensor (not shown). The first temperature sensor is arranged at the liquid return pipe 12 to detect a first temperature of the coolant in the liquid return pipe 12, that is, the temperature of the coolant at the outlet of the liquid-cooled cabinet 2. The second temperature sensor is arranged at the liquid supply pipe 11 to detect a second temperature of the coolant in the liquid supply pipe 11, that is, the temperature of the coolant at the inlet of the liquid-cooled cabinet 2.

In some embodiments, an operating frequency of the first fan 32 may be adjusted based on the first temperature of the coolant in the liquid return pipe 12. In order to realize the adjustment of the operating frequency of the first fan 32, a first threshold and a second threshold may be preset, where the second threshold is greater than the first threshold. In the case where the first temperature is greater than the first threshold and less than the second threshold, the first fan 32 may operate at a first frequency, which is a stable operating frequency of the first fan 32. In the case where the first temperature is less than the first threshold, that is, the temperature is relatively low, the first fan 32 may operate at a frequency lower than the first frequency, thereby saving electricity. In the case where the first temperature is equal to the first threshold, the first fan 32 may operate at the first frequency or a frequency lower than the first frequency, which is not limited by the embodiments of the present disclosure. In the case where the first temperature is higher than the second threshold, that is, the temperature is relatively high, the first fan 32 may operate at a frequency higher than the first frequency, thereby improving heat dissipation performance of the dry cooler 31. In the case where the first temperature is equal to the second threshold, the first fan 32 may operate at the first frequency or a frequency higher than the first frequency, which is not limited by the embodiments of the present disclosure. In the embodiments according to the present disclosure, the first threshold and the second threshold may differ by any suitable value, which may be set as required.

In some embodiments, in order to save electricity, the second fan 42 is in an off state when the dry cooler 31 and the first fan 32 can provide sufficient cooling capacity, and is only turned on when the dry cooler 31 and the first fan 32 cannot provide sufficient cooling capacity. For example, the second fan 42 may be turned on when the first fan 32 operates at a maximum frequency and the first temperature is greater than the second threshold, and turned off in other cases. In this manner, a good balance between power consumption and cooling effect may be provided.

In some embodiments, the operating frequency of the circulating pump 5 may be flexibly adjusted as required to change its capability in pumping the coolant. For example, the circulating pump 5 may adjust its operating frequency based on the first temperature. When the first temperature is relatively high, the operating frequency of the circulating pump 5 may be increased to increase the flow of the coolant supplied to the liquid-cooled cabinet 2. When the first temperature is relatively low, the operating frequency of the circulating pump 5 may be reduced to reduce the flow of the coolant.

In some embodiments, in order to detect the flow of the coolant in the pipeline of the emergency cooling supply device 100, the emergency cooling supply device 100 further includes a flowmeter for detecting the flow of the coolant in the liquid supply pipe 11 or the liquid return pipe 12.

In some embodiments, the operating frequency of the first fan 32 may be adjusted based on the difference between the first temperature of the coolant in the liquid return pipe 12 and the second temperature of the coolant in the liquid supply pipe 11. To this end, a third threshold and a fourth threshold may be preset, where the fourth threshold is greater than the third threshold. In the case where the temperature difference is greater than the third threshold and less than the fourth threshold, the first fan 32 may operate at a second frequency, which is a stable operating frequency of the first fan 32. The second frequency may be the same as or different from the first frequency, which is not limited by the embodiments of the present disclosure. In the case where the temperature difference is less than the third threshold, that is, the temperature difference is relatively small, the first fan 32 may operate at a frequency lower than the second frequency. The small temperature difference indicates that the electronic devices in the liquid-cooled cabinet 2 emit less heat, and therefore the first fan 32 operating at a low frequency can save power while ensuring sufficient cooling capacity. In the case where the temperature difference is equal to the third threshold, the first fan 32 may operate at the second frequency or a frequency lower than the second frequency, which is not limited by the embodiments of the present disclosure. In the case where the temperature difference is higher than the fourth threshold, that is, the temperature is relatively high, the first fan 32 may operate at a frequency higher than the second frequency, thereby improving heat dissipation performance of the dry cooler 31. In the case where the temperature difference is equal to the fourth threshold, the first fan 32 may operate at the second frequency or a frequency higher than the second frequency, which is not limited by the embodiments of the present disclosure. In the embodiments according to the present disclosure, the third threshold and the fourth threshold may differ by any suitable value, which may be set as required.

In some embodiments, the second fan 42 may be turned on when the first fan 32 operates at a maximum frequency and the difference between the first temperature and the second temperature is greater than the fourth threshold, and turned off in other cases. In this manner, a good balance between power consumption and cooling effect can be provided.

In some embodiments, the circulating pump 5 may adjust its operating frequency based on the difference between the first temperature and the second temperature. When the temperature difference is relatively large, the operating frequency of the circulating pump 5 may be increased to increase the flow of the coolant supplied to the liquid-cooled cabinet 2. When the temperature difference is relatively small, the operating frequency of the circulating pump 5 may be reduced to reduce the flow of the coolant.

FIG. 2 illustrates a schematic structural diagram of an emergency cooling supply device for a data center according to another embodiment of the present disclosure. The structure of the emergency cooling supply device 100 shown in FIG. 2 is similar to the structure of the emergency cooling supply device 100 shown in FIG. 1. Only the differences between the two will be described below, while the same parts will not be repeated.

As shown in FIG. 2, in some embodiments, the emergency cooling supply device 100 further includes a third valve 73. One end of the third valve 73 is connected to a pipeline between the first valve 71 and the liquid storage tank 41. The other end of the third valve 73 is connected to a pipeline between the second valve 72 and the liquid storage tank 41. The third valve 73 is closed when the first fan 32 operates at the maximum frequency and the temperature of the coolant in the liquid return pipe 12 or the difference between the temperature of the coolant in the liquid return pipe 12 and the temperature of the coolant in the liquid supply pipe 11 is greater than a predetermined threshold, and is opened in other cases. When the third valve 73 is closed, the coolant from the dry cooler 31 completely flows into the liquid storage tank 41 for further cooling. When the third valve 73 is opened, a part of the coolant from the dry cooler 31 flows into the liquid storage tank 41, and the other part flows through the third valve 73.

In some embodiments, the third valve 73 may be closed when the first fan 32 operates at the maximum frequency and the first temperature of the coolant in the liquid return pipe 12 is higher than the second threshold as described above, and the third valve 73 may be opened when the first fan 32 operates at a frequency lower than the maximum frequency or the first temperature of the coolant in the liquid return pipe 12 is lower than the second threshold.

In some embodiments, the third valve 73 may be closed when the first fan 32 operates at the maximum frequency and the difference between the first temperature of the coolant in the liquid return pipe 12 and the second temperature of the coolant in the liquid supply pipe 11 is higher than the fourth threshold as described above, and the third valve 73 may be opened when the first fan 32 operates at a frequency lower than the maximum frequency or the temperature difference is lower than the fourth threshold.

In some embodiments, the third valve 73 may be an electric valve, and the electric valve may have an opening and closing function or may further have an opening and closing degree adjustment function. In other embodiments, the third valve 73 may be a manual valve or a valve of any suitable type.

According to the embodiments of the present disclosure, in a case where the cold plate liquid cooling system of the liquid-cooled cabinet fails, the emergency cooling supply device may be adopted to connect to the liquid-cooled cabinet to provide emergency cooling to the liquid-cooled cabinet through the dry cooler, the liquid storage tank and the circulating pump, thereby ensuring that the electronic devices in the liquid-cooled cabinet may still operate reliably when the cold plate liquid cooling system fails.

Embodiments of the present disclosure are also embodied in the following examples.

Example 1. An emergency cooling supply device for a data center, including: a liquid supply pipe and a liquid return pipe, configured to be connected to a liquid-cooled cabinet in the data center; a dry cooler, connected to the liquid return pipe and configured to cool, with air, a coolant received from the liquid-cooled cabinet via the liquid return pipe; a first fan, arranged adjacent to the dry cooler and configured to drive air to flow through the dry cooler; a liquid storage tank, connected to the dry cooler via a first valve and configured to store the coolant and mix the coolant received from the dry cooler with the stored coolant; and a circulating pump, having an inlet connected to the liquid storage tank via a second valve and an outlet connected to the liquid supply pipe, the circulating pump being configured to circulate the coolant from the liquid storage tank to the liquid supply pipe and provide the coolant to the liquid-cooled cabinet via the liquid supply pipe.

Example 2. The emergency cooling supply device according to Example 1, further including an exhaust valve and an exhaust pipe, the exhaust valve being arranged in the liquid supply pipe, one end of the exhaust pipe being connected to the exhaust valve and the other end being connected to the liquid storage tank, to discharge gas in the liquid supply pipe into the liquid storage tank in accordance with the first valve and the second valve being initially opened, and a top end of the liquid storage tank being provided with a filter screen to discharge the gas.

Example 3. The emergency cooling supply device according to Example 1, further including a first temperature sensor, the first temperature sensor being arranged at the liquid return pipe to detect a first temperature of the coolant in the liquid return pipe, where the first fan is configured to operate at a first frequency in accordance with the first temperature being greater than a first threshold and less than a second threshold, operate at a frequency lower than the first frequency in accordance with the first temperature being less than the first threshold, and operate at a frequency higher than the first frequency in accordance with the first temperature being higher than the second threshold.

Example 4. The emergency cooling supply device according to Example 3, further including a second fan, the second fan being arranged adjacent to the liquid storage tank to drive air to flow through the liquid storage tank, where the second fan is configured to be turned on in accordance with the first fan operating at a maximum frequency and the first temperature being greater than the second threshold.

Example 5. The emergency cooling supply device according to Example 3, where the circulating pump is configured to adjust its operating frequency based on the first temperature.

Example 6. The emergency cooling supply device according to Example 1, further including a first temperature sensor and a second temperature sensor, the first temperature sensor being arranged at the liquid return pipe to detect a first temperature of the coolant in the liquid return pipe, the second temperature sensor being arranged at the liquid supply pipe to detect a second temperature of the coolant in the liquid supply pipe, where the first fan is configured to operate at a second frequency in accordance with the difference between the first temperature and the second temperature being greater than a third threshold and less than a fourth threshold, operate at a frequency lower than the second frequency in accordance with the difference being less than the third threshold, and operate at a frequency higher than the second frequency in accordance with the difference being greater than the fourth threshold.

Example 7. The emergency cooling supply device according to Example 6, further including a second fan, the second fan being arranged adjacent to the liquid storage tank to drive air to flow through the liquid storage tank, where the second fan is configured to be turned on in accordance with the first fan operating at a maximum frequency and the difference being greater than the fourth threshold.

Example 8. The emergency cooling supply device according to Example 7, where the circulating pump is configured to adjust its operating frequency based on the difference.

Example 9. The emergency cooling supply device according to Example 1, further including a third valve, one end of the third valve being connected to a pipeline between the first valve and the liquid storage tank, and the other end of the third valve being connected to a pipeline between the second valve and the liquid storage tank, where the third valve is configured to be closed in accordance with the first fan operating at a maximum frequency and the temperature of the coolant in the liquid return pipe or the difference between the temperature of the coolant in the liquid return pipe and the temperature of the coolant in the liquid supply pipe being greater than a predetermined threshold.

Example 10. The emergency cooling supply device according to Example 1, further including a flowmeter, the flowmeter being configured to detect the flow of the coolant in the liquid supply pipe or the liquid return pipe.

Example 11. The emergency cooling supply device according to Example 1, further including a box and rollers arranged on the box, the box accommodating the dry cooler, the first fan, the liquid storage tank and the circulating pump.

Example 12. The emergency cooling supply device according to Example 1, where the first valve and the second valve are electric valves.

The embodiments of the present disclosure have been described above, and the above description is for purpose of example, not exhaustive, and is not limited to the disclosed embodiments. Many modifications and variations will be apparent to those skilled in the art without departing from the scope and spirit of the illustrated embodiments. The choice of terms used herein is intended to best explain the principles, practical applications or technical improvements in the market of the embodiments, or to enable other skilled in the art to understand the embodiments disclosed herein.

## Claims

1. An emergency cooling supply device (100) for a data center, comprising:
a liquid supply pipe (11) and a liquid return pipe (12), configured to be connected to a liquid-cooled cabinet (2) in the data center;
a dry cooler (31), connected to the liquid return pipe (12) and configured to cool, with air, a coolant received from the liquid-cooled cabinet (2) via the liquid return pipe (12);
a first fan (32), arranged adjacent to the dry cooler (31) and configured to drive air to flow through the dry cooler (31);
a liquid storage tank (41), connected to the dry cooler (31) via a first valve (71) and configured to store coolant and mix the coolant received from the dry cooler (31) with the stored coolant; and
a circulating pump (5), having an inlet connected to the liquid storage tank (41) via a second valve (72) and an outlet connected to the liquid supply pipe (11), the circulating pump (5) being configured to circulate the coolant from the liquid storage tank (41) to the liquid supply pipe (11) and provide the coolant to the liquid-cooled cabinet (2) via the liquid supply pipe (11).

2. The emergency cooling supply device (100) according to claim 1, further comprising an exhaust valve (61) and an exhaust pipe (62), the exhaust valve (61) being arranged in the liquid supply pipe (11), one end of the exhaust pipe (62) being connected to the exhaust valve (61) and the other end being connected to the liquid storage tank (41), to discharge gas in the liquid supply pipe (11) into the liquid storage tank (41) in accordance with the first valve (71) and the second valve (72) being initially opened, and a top end of the liquid storage tank (41) being provided with a filter screen to discharge the gas.

3. The emergency cooling supply device (100) according to claim 1, further comprising a first temperature sensor, the first temperature sensor being arranged at the liquid return pipe (12) to detect a first temperature of the coolant in the liquid return pipe (12),
wherein the first fan (32) is configured to operate at a first frequency in accordance with the first temperature being greater than a first threshold and less than a second threshold, operate at a frequency lower than the first frequency in accordance with the first temperature being less than the first threshold, and operate at a frequency higher than the first frequency in accordance with the first temperature being higher than the second threshold.

4. The emergency cooling supply device (100) according to claim 3, further comprising a second fan (42), the second fan (42) being arranged adjacent to the liquid storage tank (41) to drive air to flow through the liquid storage tank (41), wherein the second fan (42) is configured to be turned on in accordance with the first fan (32) operating at a maximum frequency and the first temperature being greater than the second threshold.

5. The emergency cooling supply device (100) according to claim 3, wherein the circulating pump (5) is configured to adjust its operating frequency based on the first temperature.

6. The emergency cooling supply device (100) according to claim 1, further comprising a first temperature sensor and a second temperature sensor, the first temperature sensor being arranged at the liquid return pipe (12) to detect a first temperature of the coolant in the liquid return pipe (12), the second temperature sensor being arranged at the liquid supply pipe (11) to detect a second temperature of the coolant in the liquid supply pipe (11),
wherein the first fan (32) is configured to operate at a second frequency in accordance with the difference between the first temperature and the second temperature being greater than a third threshold and less than a fourth threshold, operate at a frequency lower than the second frequency in accordance with the difference being less than the third threshold, and operate at a frequency higher than the second frequency in accordance with the difference being greater than the fourth threshold.

7. The emergency cooling supply device (100) according to claim 6, further comprising a second fan (42), the second fan (42) being arranged adjacent to the liquid storage tank (41) to drive air to flow through the liquid storage tank (41), wherein the second fan (42) is configured to be turned on in accordance with the first fan (32) operating at a maximum frequency and the difference being greater than the fourth threshold.

8. The emergency cooling supply device (100) according to claim 7, wherein the circulating pump (5) is configured to adjust its operating frequency based on the difference.

9. The emergency cooling supply device (100) according to claim 1, further comprising a third valve (73), one end of the third valve (73) being connected to a pipeline between the first valve (71) and the liquid storage tank (41), and the other end of the third valve (73) being connected to a pipeline between the second valve (72) and the liquid storage tank (41), wherein the third valve (73) is configured to be closed in accordance with the first fan (32) operating at a maximum frequency and the temperature of the coolant in the liquid return pipe (12) or the difference between the temperature of the coolant in the liquid return pipe (12) and the temperature of the coolant in the liquid supply pipe (11) being greater than a predetermined threshold.

10. The emergency cooling supply device (100) according to claim 1, further comprising a flowmeter, the flowmeter being configured to detect a flow of the coolant in the liquid supply pipe (11) or the liquid return pipe (12).

11. The emergency cooling supply device (100) according to claim 1, further comprising a box and rollers arranged on the box, the box accommodating the dry cooler (31), the first fan (32), the liquid storage tank (41) and the circulating pump (5).

12. The emergency cooling supply device (100) according to claim 1, wherein the first valve (71) and the second valve (72) are electric valves.
